# EUROPÄISCHE PATENTANMELDUNG

(11) **EP 0 899 789 A1**
(43) Veröffentlichungstag der Anmeldung: **03.03.1999**
(21) Anmeldenummer: 98114959.4
(22) Anmeldetag: 08.08.1998
(51) Int. Cl.: H01L 23/62

(54) **Uberspannungsschutzelement**

(30) Priorität: 23.08.1997 DE 19736754
(71) Anmelder: Micronas Intermetall GmbH, 79108 Freiburg (DE)
(72) Erfinder: Igel, Günter, Dipl.-Ing., 79331 Teningen (DE); Krumrey, Joachim, Dipl.-Phys., 79106 Freiburg (DE)
(74) Vertreter: Hornig, Leonore, Dr.

(57) **Zusammenfassung**

Die Erfindung betrifft ein Überspannungsschutzelement und ein Verfahren zur Herstellung eines Überspannungsschutzelements. Auf einem Substrat 1 sind eine erste Elektrodenschicht 2 und eine zweite Elektrodenschicht 3 übereinander aufgebracht und weisen zueinander ein Abstand d auf, der durch die Dicke einer Abstandsschicht 4 bestimmt ist. Die Abstandsschicht 4 weist eine Durchbrechung 5 auf, die zwischen den Elektrodenschichten 2, 3 einen Hohlraum 6 bildet.

## Beschreibung

Die Erfindung betrifft ein Überspannungsschutzelement.

Als Überspannungsschutzelemente sind Halbleiterbauelemente, insbesondere Zenerdioden und Varistoren, sowie Gasentladungsbauelemente bekannt. Derartige Überspannungsschutzelemente sind aus 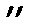 Transient Voltage Suppression Devices", Harris Semiconductor, Harris Corporation, 1990, insbesondere Kapitel II, bekannt. Es sind dort verschiedene Eigenschaften von unterschiedlichen Halbleiterbauelementen und einem Gasentladungsbauelement beschrieben. Die Halbleiterbauelemente haben insbesondere den Nachteil eines hohen Leckstroms, der zu einem permanenten Leistungsverlust führt. Eine niedere Abbruchspannung ist technisch schwer realisierbar und führt zu einem hohen Leckstrom. Auch weisen sie eine relativ hohe Sperrschichtkapazität auf, was zu einer relativ langsamen Reaktionszeit führt. Gasentladungsbauelemente haben günstigere Leckstromeigenschaften und somit einen geringeren Leistungsverlust. Jedoch sind Gasentladungsbauelemente nicht als Niederspannungsschutzelemente einsetzbar, da mit ihnen ein Überspannungsschutz erst deutlich über 100 V möglich ist. Ferner weisen sie eine große Toleranz bezüglich ihrer Nennspannung auf. Die Halbleiterbauelemente haben den Nachteil, daß zu ihrer Integration eine große Chipfläche benötigt wird. Die Gasentladungsbauelemente sind nicht integrierbar.

Der Erfindung liegt die Aufgabe zugrunde, ein Überspannungsschutzelement sowie ein Verfahren zur Herstellung eines Überspannungsschutzelements zu schaffen, welches einen geringen Leckstrom und somit einen geringen Leisturigsverlust, eine geringe Reaktionszeit und eine niedrige Abbruchspannung aufweist, so daß es als Niederspannungsschutzelement geeignet ist.

Diese Aufgabe wird durch ein Überspannungsschutzelement mit einem Substrat mit einer darauf aufgebrachten ersten Elektrodenschicht und einer darüber angeordneten zweiten Elektrodenschicht gelöst, die von der ersten einen Abstand d aufweist, der durch die Dicke einer Abstandsschicht bestimmt ist, wobei die Abstandsschicht eine Durchbrechung aufweist, die zwischen den Elektrodenschichten einen Hohlraum bildet.

Das erfindungsgemäße Überspannungsschutzelement ist somit auf einem Substrat ausgebildet, so daß es integrationsfähig ist. Es hat die Wirkungsweise eines Gasentladungselements. Aufgrund der Technologie kann es so ausgebildet werden, daß es zum Überspannungsschutz für niedere Spannungen geeignet ist. Da es in dem Substrat in Mikrotechnologie hergestellt werden kann, kann die Geometrie sehr Klein und genau definiert werden. Es kann somit ein Überspannungsschutzelement hergestellt werden, das zum Überspannungsschutz für niedere Spannungen geeignet ist und eine geringe Toleranz der Nennspannung aufweist. Ferner ist der Leckstrom gering und es weist eine geringe elektrische Kapazität auf, so daß es auch eine geringe Reaktionszeit aufweist.

Ferner wird die Aufgabe durch ein Verfahren zum Herstellen eines Überspannungsschutzelementes gelöst, bei dem auf ein Substrat eine erste Elektrodenschicht, eine Abstandsschicht und eine zweite Elektrodenschicht übereinander aufgebracht werden, wobei die Abstandsschicht mit wenigstens einer Durchbrechung ausgebildet wird, die zwischen den Elektrodenschichten einen Hohlraum bildet. In diesem Verfahren kann das Überspannungsschutzelement mit den oben beschriebenen Vorteilen, auf einfache Weise in der Mikrotechnologie, mit bekannten Prozessen hergestellt werden.

Bevorzugte Ausführungsbeispiele der Erfindung werden in den Unteransprüchen offenbart.

Gemäß einem vorteilhaften Ausführungsbeispiel der Erfindung weist die erste Elektrodenschicht ein elektronenemittierendes Material mit einer sehr Kleinen Austrittsarbeit für Elektronen auf. Dann wird die erste Elektrodenschicht als Emitterelektrode verwendet, und die zweite Elektrodenschicht bildet das Gegenpotential, das nach der Entladung in dem Hohlraum die Elektronen absaugt. Es kann die zweite Elektrodenschicht ein elektronenemittierendes Material mit einer sehr Kleinen Austrittsarbeit für Elektkronen aufweisen. Wenn gleichzeitig die erste Elektrodenschicht ein elektronenemittierendes Material mit einer sehr Kleinen Austrittsarbeit für Elektronen aufweist, ist das Überspannungsschutzelement polungsinvariant.

Günstigerweise kann der Hohlraum mit einem Gas gefüllt sein. Die Art des Gases kann frei bzw. für bestimmte Eigenschaften geeignet gewählt werden; beispielsweise können Edelgase oder andere Gase mit günstigen Gasentladungseigenschaften verwendet werden. Mit den speziell gewählten Gasen können gezieltere Eigenschaften des Überspannungsschutzelements eingestellt werden, als dies mit Luft möglich wäre. Die Art und Menge des Gases sowie die Geometrie der Anordnung können so gewählt sein, daß eine vorgegebene, zum Überspannungsschutz geeignete Spannung U₀ definiert wird. Eine wesentliche Größe ist hierbei der Abstand d zwischen den Elektrodenschichten.

Es ist vorteilhaft wenn eine Elektrodenschicht eine ausgeprägte Oberflächenstruktur aufweist. Diese kann durch eine gewisse Rauhigkeit der Oberfläche zustande kommen, welche das Emissionsvermögen von Primärelektronen aus der ersten Elektrodenschicht erhöht. Durch die Rauhigkeit der Oberfläche kann die Feldstärke lokal erhöht werden. Diese Eigenschaft kann dadurch besonders stark ausgeprägt werden, daß Spitzen auf der Oberfläche ausgebildet werden.

Gemäß einem bevorzugten Ausführungsbeispiel der Erfindung umfaßt das Substrat einen Halbleiterkörper. Dann läßt sich das Überspannungsschutzelement einfach, mit den in der Halbleitertechnologie üblichen Prozessen herstellen. Es kann auf dem Halbleiterkörper selbst hergestellt werden, so daß es automatisch in die Halbleiteranordnung integriert ist. Die Anordnung des Überspannungsschutzelements auf dem Halbleiterkörper ermöglicht zudem eine platzsparende Anordnung, die besonders im Halbleiterbereich wegen der hohen Materialkosten vorteilhaft ist. Auf dem Substrat kann eine Isolatorschicht aufgebracht sein. Dies ist insbesondere dann vorteilhaft, wenn als Substrat kein Isolator verwendet wird und eine höhere Isolationseigenschaft gewünscht ist.

Gemäß einem bevorzugten Ausführungsbeispiel der Erfindung entspricht die Isolatorschicht der Passivierungsschicht eines IC-Elements. In diesem Ausführungsbeispiel kann zunächst das IC-Element mit den üblichen Prozeßschritten hergestellt werden, und danach können die für das Überspannungsschutzelement erforderlichen Schritte weiter ausgeführt werden. Diese sind mit den zur Herstellung des IC-Elements erforderlichen Prozeßschritten kompatibel. Es wird eine gute Isolation zu dem Halbleiterkörper erreicht, ohne daß eine zusätzliche Isolatorschicht aufgebracht werden muß. Die Elektroden und die Abstandsschicht können auch innerhalb der Passivierungsschicht ausgebildet sein. In diesem Fall werden zusätzliche Maskierungsschritte gespart, da die für das Überspannungsschutzelement erforderlichen Schichten in dem normalen Herstellungsverfahren des IC-Elements mitausgebildet werden können.

Gemäß einem Ausführungsbeispiel der Erfindung wird die Abstandsschicht aus einem Material gebildet, das eine wesentlich größere Ätzrate als das Material der Elektrodenschicht aufweist, und die Durchbrechung in der Abstandsschicht wird dadurch gebildet, daß in der zweiten Elektrodenschicht Öffnungen ausgebildet werden, durch welche die Abstandsschicht bis zu der ersten Elektrodenschicht so geätzt wird, daß seitlich der Durchbrechung Bereiche der Abstandsschicht erhalten bleiben. Aufgrund des Unterschieds in der Ätzrate bleiben bei diesem Verfahren die Elektrodenschichten im wesentlichen erhalten und die Abstandsschicht kann soweit weggeätzt werden, daß zwischen den Elektrodenschichten ein Hohlraum ausgebildet wird. Die verbleibenden Bereiche der Abstandsschicht dienen als Stütze und zur Bestimmung des Abstandes der Elektrodenschichten.

Gemäß einem zweiten Ausführungsbeispiel der Erfindung wird die Durchbrechung in der Abstandsschicht vor dem Aufbringen der zweiten Elektrodenschicht ausgebildet und letztere durch Aufbringen eines festen, plattenförmigen Materials erzeugt. In dem plattenförmigen Material kann eine Öffnung vorgesehen sein, die es ermöglicht, den Hohlraum mit Gas zu füllen. Das Gas kann aber auch durch seitliche Öffnungen in den Hohlraum eingebracht werden. Die Elektrodenschicht kann lösbar oder unlösbar befestigt werden. Eine lösbare Befestigung kann beispielsweise durch Klemmen erfolgen, was zu einer zuverlässigen und dauerhaften Kontaktierung führt. Eine unlösbare Befestigung kann durch Löten, Kleben u.ä. erfolgen. Das Überspannungsschutzelement kann selbstverständlich auch mit mehreren Durchbrechungen ausgebildet werden. In dem Fall, in dem die zweite Elektrodenschicht durch Aufbringen eines plattenförmigen Materials erzeugt wird, kann für dieses beispielsweise ein Lochblech verwendet werden. Das Lochblech muß dann so auf die Abstandsschicht aufgebracht werden, daß die Löscher zu den Durchbrechungen der Abstandsschicht korrespondierend angeordnet werden. Wenn ein festes plattenförmiges Material als zweite Elektrodenschicht aufgebracht wird, kann dieses auch als Deckel des Überspannungsschutzelements bzw. des IC-Elements verwendet werden.

Es ist vorteilhaft, wenn das Gas wahrend der Montage der Anordnung in den Hohlraum eingebracht wird. In diesem Fall wird das Überspannungsschutzelement ohnehin gegen die Außenwelt verschlossen, so daß das Gas weder entweichen noch verunreinigt werden kann. Wenn die Montage durch Löten erfolgt, kann ein Gas verwendet werden, das auch für den Lötprozeß geeignet ist. Dabei wird ausgenutzt, daß viele für die Gasentladung geeignete Gase auch das Löten begünstigen.

Im folgenden wird die Erfindung anhand der Zeichnung näher beschrieben.
Fig. 1 zeigt ein Ausführungsbeispiel eines erfindungsgemäßen Überspannungsschutzelements,
Fig. 2 ein anderes Ausführungsbeispiel des erfindungsgemäßen Überspannungsschutzelements und
Fig. 3 ein weiteres Ausführungsbeispiel des erfindungsgemäßen Überspannungsschutzelements.

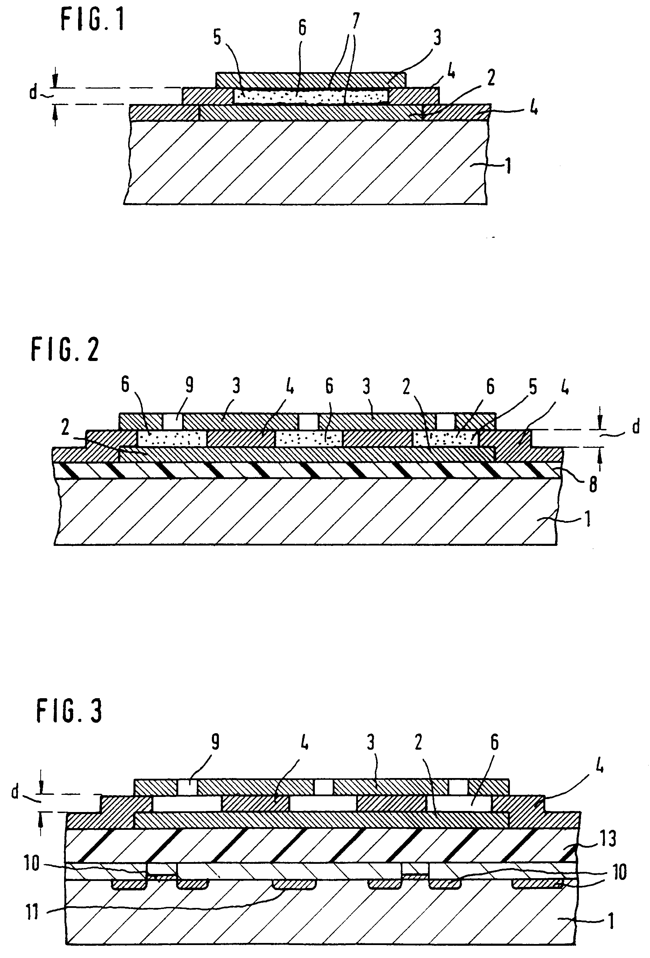

Das in der Fig. 1 gezeigte Ausführungsbeispiel eines Überspannungsschutzelements weist ein Substrat 1 auf. Das Substrat 1 kann beispielsweise aus einem Isolator wie Glas oder einem Halbleitermaterial wie Silizium bestehen. Auf dem Substrat 1 sind eine erste Elektrodenschicht 2 und darüber eine zweite Elektrodenschicht 3 angeordnet. Zwischen der ersten Elektrodenschicht 2 und der zweiten Elektrodenschicht 3 ist eine Abstandsschicht 4 ausgebildet, die eine Dicke aufweist, durch welche ein Abstand d zwischen der ersten Elektrodenschicht 2 und der zweiten Elektrodenschicht 3 vorgegeben wird. Die Abstandsschicht 4 weist eine Durchbrechung 5 auf, die zwischen den Elektrodenschichten 2, 3 einen Hohlraum 6 bildet.

Es können sowohl die erste Elektrodenschicht 2, die zweite Elektrodenschicht 3 oder beide Elektrodenschichten 2, 3 ein elektronenemittierendes Material mit einer sehr kleinen Austrittsarbeit für Elektronen aufweisen. Der Hohlraum 5 kann mit Luft oder mit einem Gas gefüllt sein. Die Art und Menge des Gases sowie die Geometrie der Anordnung sind so gewählt, daß eine vorgegebene, zum Überspannungsschutz geeignete Spannung U₀ definiert ist. In dem gezeigten Ausführungsbeispiel weist die Oberfläche 7 der ersten Elektrodenschicht 2 und der zweiten Elektrodenschicht 3 eine Oberflächenstruktur auf. Dadurch wird das Elektronenemissionsvermögen der jeweiligen Elektrodenschicht 2, 3 erhöht. Es kann dadurch zudem ein lokal entlang der Oberfläche variierendes Emissionsvermögen der Elektronen erzielt werden.

Man erhält in dieser Anordnung ein Überspannungsschutzelement, welches nach dem Prinzip eines Gasentladungselementes funktioniert und gleichzeitig auf einem Substrat in der Mikrotechnologie integriert hergestellt werden kann.

Fig. 2 zeigt ein weiteres Ausführungsbeispiel des Überspannungsschutzelementes. Auf dem Substrat 1 ist eine Isolatorschicht 8 aufgebracht. Wenn in dem gezeigten Ausführungsbeispiel das Substrat 1 ein Kalbleiterkörper ist, wird dieser durch die Isolatorschicht 8 von der ersten Elektroderschicht 2 isoliert. Die zwischen der ersten Elektrodenschicht 2 und der zweiten Elektrodenschicht 3 angeordnete Abstandsschicht 4 weist an drei Stellen Durchbrechungen 5 auf, welche jeweils einen Hohlraum 6 bilden. Die Hohlräume 6 sind jeweils mit einem geeignet gewählten Gas gefüllt, welches die zum Überspannungsschutz geeignete Spannung U₀ mitbestimmt. Die verbleibenden Bereiche der Abstandsschicht 4 definieren den Abstand d zwischen der ersten und der zweiten Elektrodenschicht 2, 3. Es wird in diesem Ausführungsbeispiel insgesamt ein großer Hohlraum 6 ausgebildet, da sich die einzelnen Hohlraumbereiche addieren. Die Zwischenbereiche der Abstandsschicht 4 haben dabei eine stützende Funktion für die zweite Elektrodenschicht 3. Es kann somit insgesamt eine größere Menge Gas in den gesamten Hohlraum 6 eingebracht werden, so daß eine höhere Empfindlichkeit des Überspannungsschutzelement erzielt werden kann. In der zweiten Elektrodenschicht 3 sind Öffnungen 9 ausgebildet, durch welche das Gas in die Hohlräume 6 gelangen kann.

Fig. 3 zeigt ein Überspannungsschutzelement, das in seiner wesentlichen Wirkungsweise und in seinem wesentlichen Aufbau dem Überspannungsschutzelement der Fig. 2 entspricht. Gleiche Elemente sind mit gleichen Bezugszeichen benannt und haben die gleiche Funktionsweise, so daß im folgenden nur die Unterschiede zu dem Überspannungsschutzelement der Fig. 2 ausgeführt werden. Bei dem Substrat 1 handelt es sich um einen Halbleitersubstrat, in dem aktive Bereiche 10 ausgebildet sind. Wie in der Figur angedeutet ist, können diese beispielsweise MOS-Transistoren, Widerstandselemente und ähnliches bilden. Es entsteht somit ein IC-Element. Seine Oberfläche ist mit einer Passivierungsschicht 13 versehen. Die Passivierungsschicht 13 ist eine Isolatorschicht, die in ihrer Wirkungsweise der Isolatorschicht 8 aus Fig. 2 entspricht. Auf der Passivierungsschicht 13 werden entsprechend der Anordnung aus Fig. 2 die erste Elektrodenschicht 2, die zweite Elektrodenschicht 3 und die Abstandsschicht 4 ausgebildet.

Es sind weitere Ausgestaltungen des erfindungsgemäßen Überspannungsschutzelements möglich. Beispielsweise kann die Anordnung aus erster Elektrodenschicht 2, der zweiten Elektrodenschicht 3 und der Abstandsschicht 4 innerhalb der Passivierungsschicht eines IC-Elements ausgebildet werden. Die erste Elektrodenschicht und die zweite Elektroderschicht können dann gleichzeitig mit Leiterbahnen ausgebildet werden, und die Abstandsschicht 4 kann mit anderen Isolatorschichten gebildet werden. Die Anzähl der ausgebildeten Hohlräume 6 kann beliebig sein. Es können pro Hohlraum 6 auch mehrere Öffnungen in der zweiten Elekrodenschicht 3 ausgebildet sein.

Im folgenden wird ein erstes Ausführungsbeispiels des erfindungsgemäßen Verfahrens anhand der Fig. 2 beschrieben. Auf das Substrat 1 wird die Isolatorschicht 8 aufgebracht. Darauf wird die erste Elektrodenschicht 2 ausgebildet und mit der Abstandsschicht 4 überdeckt. Auf die Abstandsschicht 4 wird die zweite Elektrodenschicht 3 aufgebracht und mit Öffnungen 9 versehen. Das Ausbilden der verschiedenen Schichten auf dem Substrat 1 erfolgt mit den in der Mikrotechnologie bekannten Verfahren. Ein Beispiel davon ist die Halbleitertechnologie, wobei das Substrat 1 ein Halbleitersubstrat ist. Die Abstandsschicht 4 wird aus einem Material gebildet, das eine wesentlich größere Ätzrate als das Material der Elektrodenschichten 2, 3 aufweist. Es wird ausgehend von der Oberfläche der zweiten Elektrodenschicht 3 die Abstandsschicht 4 durch die Öffnungen 9 geätzt. Aufgrund der unterschiedlichen Ätzrate des Materials der Abstandsschicht 4 und der Elektrodenschichten 2, 3 erfolgt eine Unterätzung der Abstandsschicht 4 hinsichtlich der ersten Elektrodenschicht 2. Das Material der ersten Elektrodenschicht 2 und der zweiten Elektrodenschicht 3 bleibt im wesentlichen erhalten, wohingegen das Material der Abstandsschicht 4 seitlich herausgeätzt wird. Der Ätzvorgang erfolgt so lange, bis Hohlräume 6 ausgebildet sind, die seitlich noch von Bereichen der Abstandsschicht 4 begrenzt werden. Danach wird das Überspannungsschutzelement auf einen Leadframe oder auf eine Leiterplatine montiert und mit einer Abdeckung versehen. Wahrend des Montageprozesses werden die Hohlräume 6 mit einem Gas gefüllt.

Gemäß einem zweiten Ausführungsbeispiel des erfindungsgemäßen Verfahrens werden die Isolatorschicht 8, die erste Elektrodenschicht 2 und die Abstandsschicht 4 analog dem zuvor beschriebenen Verfahren aufgebracht. Danach werden die Durchbrechungen 5 in der Abstandsschicht 4 ausgebildet. Dies erfolgt mit in der Mikrotechnologie üblichen Verfahren, insbesondere mit herkömmlichen Maskierungs- und Ätzverfahren. Danach wird ein plattenförmiges Material als zweite Elektrodenschicht 3 auf die Abstandsschicht 4 aufgebracht und an dieser befestigt. Das Befestigen kann unlösbar, beispielsweise durch Kleben oder Bonden, oder lösbar, beispielsweise durch Klemmen, erfolgen. Im gezeigten Ausführungsbeispiel weist das plattenförmige Material Öffnungen 9 auf, die nach dem Aufbringen der zweiten Elektrodenschicht 3 mit den Durchbrechungen 5 der Abstandsschicht 4 korrespondieren.

## Patentansprüche

1. Überspannungsschutzelement mit einem Substrat (1) mit einer darauf aufgebrachten ersten Elektrodenschicht (2) und einer darüber angeordneten zweiten Elektrodenschicht (3), die von der ersten einen Abstand d aufweist, der durch die Dicke einer Abstandsschicht (4) bestimmt ist, wobei die Abstandsschicht (4) eine Durchbrechung (5) aufweist, die zwischen den Elektrodenschichten (2, 3) einen Hohlraum (6) bildet.

2. Überspannungsschutzelement nach Anspruch 1, dadurch gekennzeichnet, daß die erste Elektrodenschicht (2) ein elektronenemittierendes Material mit einer sehr kleinen Austrittsarbeit für Elektronen aufweist.

3. Überspannungsschutzelement nach einem der vorangehenden Ansprüche, dadurch gekennzeichnet, daß die zweite Elektrodenschicht (3) ein elektronen-emittierendes Material mit einer sehr kleinen Austrittsarbeit für Elektronen aufweist.

4. Überspannungsschutzelement nach einem der vorangehenden Ansprüche, dadurch gekennzeichnet, daß der Hohlraum (6) mit einem Gas gefüllt ist.

5. Überspannungsschutzelement nach einem der vorangehenden Ansprüche, dadurch gekennzeichnet, daß die Art und Menge des Gases sowie die Geometrie der Anordnung so gewählt sind, daß eine vorgegebene, zum Überspannungsschutz geeignete Spannung U₀ definiert ist.

6. Überspannungsschutzelement nach einem der vorangehenden Ansprüche, dadurch gekennzeichnet, daß wenigstens eine Elektrodenschicht (2, 3) eine spezielle Oberflächenstruktur aufweist.

7. Überspannungsschutzelement nach einem der vorangehenden Ansprüche, dadurch gekennzeichnet, daß das Substrat (1) einen Halbleiterkörper umfaßt.

8. Überspannungsschutzelement nach einem der vorangehenden Ansprüche, dadurch gekennzeichnet, daß auf dem Substrat (1) eine Isolatorschicht (8) aufgebracht ist.

9. Überspannungsschutzelement nach einem der vorangehenden Ansprüche, dadurch gekennzeichnet, daß die Isolatorschicht (8) der Passivierungsschicht (13) eines IC-Elements entspricht.

10. Überspannungsschutzelement nach einem der vorangehenden Ansprüche, dadurch gekennzeichnet, daß die Elektroden (2, 3) und die Abstandsschicht (4) innerhalb der Passivierungsschicht eines IC-Elements ausgebildet sind.

11. Verfahren zum Herstellen eines Überspannungsschutzelements, bei dem auf ein Substrat eine erste Elektrodenschicht (2), eine Abstandsschicht (4) und eine zweite Elektrodenschicht (3) übereinander aufgebracht werden, wobei die Abstandsschicht (4) mit wenigstens einer Durchbrechung (5) ausgebildet wird, die zwischen den Elektrodenschichten (2, 3) einen Hohlraum (6) bildet.

12. Verfahren nach Anspruch 11, dadurch gekennzeichnet, daß der Hohlraum (6) zwischen den Elektrodenschichten (2, 3) mit Gas gefüllt wird.

13. Verfahren nach einem der Ansprüche 11 bis 12, dadurch gekennzeichnet, daß die Abstandsschicht (4) aus einem Material gebildet wird, das eine wesentlich größere Ätzrate als das Material der Elektrodenschichten (2, 3) aufweist, und die Durchbrechung (5) in der Abstandsschicht (4) dadurch gebildet wird, daß in der zweiten Elektrodenschicht (3) Öffnungen (9) ausgebildet werden, durch welche die Abstandsschicht (4) bis zu der ersten Elektrodenschicht (2) so geätzt wird, daß seitlich der Durchbrechung (5) Bereiche der Abstandsschicht (4) erhalten bleiben.

14. Verfahren nach einem der Ansprüche 11 bis 12, dadurch gekennzeichnet, daß die Durchbrechung (5) in der Abstandsschicht (4) vor dem Aufbringen der zweiten Elektrodenschicht (3) ausgebildet wird, und letztere durch Aufbringen eines festen, plattenförmiges Materials erzeugt wird.

15. Verfahren nach Anspruch 14, dadurch gekennzeichnet, daß die zweite Elektrodenschicht (3) lösbar oder unlösbar befestigt wird.

16. Verfahren nach einem der Ansprüche 11 bis 15, dadurch gekennzeichnet, daß das Gas wahrend der Montage der Anordnung in den Hohlraum (6) eingebracht wird.

17. Verfahren nach einem der Ansprüche 11 bis 16, dadurch gekennzeichnet, daß vor dem Aufbringen der ersten Elektrodenschicht (2) eine Isolatorschicht (8) auf das Substrat (1) aufgebracht wird.
